# EUROPEAN PATENT SPECIFICATION

(11) **EP 3 087 629 B1**
(45) Date of publication and mention of the grant of the patent: **27.03.2019**
(21) Application number: 13814164.3
(22) Date of filing: 23.12.2013
(51) Int. Cl.: H01M 4/04, H01M 4/1395, H01M 4/38, H01M 4/134, H01M 4/02, H01L 21/02, H01M 10/052

(54) **METHOD FOR PRODUCING A POROUS NANOCRYSTALLINE SEMICONDUCTOR LAYER, POROUS NANOCRYSTALLINE SEMICONDUCTOR LAYER, USE THEREOF, ANODE, AND SECONDARY LITHIUM-ION BATTERY**
VERFAHREN ZUR HERSTELLUNG EINES PORÖSEN NANOKRISTALLINEN HALBLEITERSCHICHT, NANOKRISTALLINE PORÖSE HALBLEITERSCHICHT, VERWENDUNG DAVON, ANODE UND LITHIUM-IONEN-SEKUNDÄRBATTERIE
PROCÉDÉ DE FABRICATION DE COUCHE SEMI-CONDUCTRICE NANOCRISTALLINE POREUSE, COUCHE SEMI-CONDUCTRICE NANOCRISTALLINE POREUSE, UTILISATION DE CETTE DERNIÈRE, ANODE ET BATTERIE LITHIUM-ION SECONDAIRE

(43) Date of publication of application: 02.11.2016
(73) Proprietor: Universität Stuttgart, 70174 Stuttgart (DE)
(72) Inventor: STRUNK, Horst, 70197 Stuttgart (DE); QU, Fei, 70825 Korntal (DE)
(74) Representative: Stolmár & Partner Patentanwälte PartG mbB
(86) International application number: PCT/EP2013/077916
(87) International publication number: WO 2015/096854

(56) References cited:
- US-A1- 2004 161 369
- US-A1- 2013 189 575
- ALFORD ET AL: "Nanocrystalline Si formation in the a-Si/Al system on polyimide and silicon dioxide substrates", THIN SOLID FILMS, ELSEVIER-SEQUOIA S.A. LAUSANNE, CH, vol. 516, no. 12, 14 March 2008 (2008-03-14), pages 3940-3947, XP022533879, ISSN: 0040-6090, DOI: 10.1016/J.TSF.2007.07.204
- KULOVA T L ET AL: "Electrode materials for lithium-ion batteries of new generation", RUSSIAN JOURNAL OF ELECTROCHEMISTRY, NAUKA/INTERPERIODICA, MO, vol. 48, no. 3, 14 March 2012 (2012-03-14) , pages 330-335, XP035028766, ISSN: 1608-3342, DOI: 10.1134/S1023193512020085

## Description

The present invention is directed to a method for producing a porous nanocrystalline semiconductor layer, a porous nanocrystalline semiconductor layer, a use thereof, an anode, and a secondary lithium-ion battery.

Silicon has turned into one of the most promising materials for anodes for secondary lithium-ion batteries, such as high energy rechargeable Li-ion batteries. However, a huge expansion (300 to 400%) during alloying with Li may induce pulverization/delamination for micro-sized electrodes, as well as undesired accumulation of solid electrolyte interphase (SEI). Many efforts have focused on various nano-engineering and binding strategies to construct integrated, robust ionic/electronic wiring networks, but with a tradeoff between active/inactive material ratio and performance retention.

To meet the demands with respect to increased energy and power densities of Li-ion batteries, e.g. for applications in hybrid electric vehicles (HEV) and plug-in HEV (PHEV), high capacity electrodes are required. In addition, there is a need for electrodes for small electronic equipment of high power needs and/or long operating times.

With respect to a negative electrode, silicon-based materials as typical alloy anodes are top candidates owing to the extremely high theoretical capacity of 4200 mAh/g, based on the formation of Li₂₂Si₅ phase, exceeding that of the widely used graphite insertion anode (372 mAh/g) by more than a factor of 10.

However, from Si to Li₂₂Si₅, a huge volume expansion ratio of about 400% (or about 300% for amorphous Si) occurs, typically leading to electrode pulverization/delamination, electrical contact loss, increased formation of solid electrolyte interphase (SEI) and early capacity degradation. Si nanostructures, such as nanowires and nanoparticles, or their composites (e.g. coated by carbon or conjugated polymer, alloying with inactive metal) with well-defined morphologies or ionic/electronic wiring networks have been exploited to address these problems (Chan, C. K., Peng, H. L., Liu, G., Mcllwrath, K., Zhang, X. F., Huggins, R. A. & Cui, Y. High performance lithium battery anodes using silicon nanowires. Nat. Nanotechnol. 3, 31-35 (2008); Xin, S., Guo, Y. G. & Wan, L. J. Nanocarbon networks for advanced rechargeable lithium batteries. Ace. Chem. Res. 45, 1759-1769 (2012); Wu, H., Yu, G. H., Pan, L. J., Liu, N., McDowell, M. T., Bao, Z. N. & Cui, Y. Stable Li-ion battery anodes by in-situ polymerization of conducting hydrogel to conformally coat silicon nanoparticles. Nat. Commun. 4, 1943 (2013)). However, Si nano-material is typically produced in complicated chemical deposition processes from explosive and toxic gases using HF.

Other strategies are to use more effective binders/additives, such as carboxymethyl cellulose (CMC), polyacrylic acid (PAA) and fluoroethylene carbonate (FEC), as well as flexible or nano-texture current collectors to strengthen the electrical contact, produce more stable solid electrolyte interphase, and improve the capacity retention. (Kovalenko, I., Zdyrko, B., Magasinski, A., Hertzberg, B., Milicev, Z., Burtovyy, R., Luzinov, I. & Yushin, G. A major constituent of brown algae for use in high-capacity Li-ion batteries. Science 334, 75-79 (2011); Etacheri, V., Haik, 0., Goffer, Y., Roberts, G. A., Stefan, I. C., Fasching, R. & Aurbach, D. Effect of fluoroethylene carbonate (FEC) on the performance and surface chemistry of Si-nanowire Li-ion battery anodes. Langmuir 28, 965-976 (2012); Choi, J. Y., Lee, D. J., Lee, Y. M., Lee, Y. G., Kim, K. M., Park, J. K. & Cho, K. Y. Silicon nanofibrils on a flexible current collector for bendable lithium-ion battery anodes. Adv. Funct. Mater. 23, 2108-2114 (2013)).

To improve the practical energy density of Li-ion batteries, an alternative method is to reduce the amount of inactive components during electrode preparation. For example, Si thin film architectures without the usage of binders and additional conductive substances have been reported, which show near theoretical capacity with good cyclability as long as the film thickness is below the critical cracking value of about 300 nm to prevent delamination or fracture of thin films from substrates during lithiation-driven volume expansion (Ohara, S., Suzuki, J., Sekine, K. & Takamura, T. A thin film silicon anode for Li-ion batteries having a very large specific capacity and long cycle life. J Power Sources 136, 303-306 (2004); Maranchi, J. P., Hepp, A. F. & Kumta, P. N. High capacity, reversible silicon thin-film anodes for lithium-ion batteries. Electrochem. Solid-State Lett. 6, A198-A201 (2003)). Otherwise, the capacity fades seriously after several cycles with repeating volume expansion and contraction as observed in 1pm thick samples.

In view of practical application, micro-sized Si thick films are required to achieve high area specific capacity, and still, most of methods previously focused on the fabrication of state-of-the-art nano-composites by using slurrying and pasting processes. The large-scale deposition of nano-architecture Si thick films, for instance having a thickness > 1 pm, without mixing with binder and conductive additives remains a significant challenge (Usui, H., Uchida, N. & Sakaguchi, H. Influence of order in stepwise electroless deposition on anode properties of thick-film electrodes consisting of Si particles coated with Ni and Cu. J Power Sources 196, 10244-10248 (2011)). A further approach was a complete layer exchange to fabricate large grain-sized Si films with high crystallinity (Jung, M., Okada, A., Saito, T., Suemasu, T. & Usami, N. On the controlling mechanism of preferential orientation of polycrystalline-silicon thin films grown by aluminum-induced crystallization. Appl. Phys. Express 3, 095803 (2010)). Aluminum-induced crystallization of trilayer structures (E.V. Jelenkovic, O. Kutsay, Shrawan K. Jha, K.C. Tam, P.F. Lee, I. Bello, Aluminum induced formation of SiGe alloy in Ge/Si/Al thin film structure, Journal of Non-Crystalline Solids 358 771-775 (2012)) and Al-induced layer exchange (Noritaka Usami, Mina Jung, Takashi Suemasu, On the growth mechanism of polycrystalline silicon thin film by Al-induced layer exchange process, Journal of crystal Growth 362, 16-19 (2013)) were also reported.

In WO 2013/147958 A2, a porous silicon based material including porous crystalline elemental silicon formed by reducing silicon dioxide with a reducing metal in a heating process followed by acid etching is used to construct a negative electrode for lithium ion batteries.

Alford et al. (Nanocrystalline Si formation in the a-Si/Al system on polyimide and silicon dioxide substrates, Thin Solid Films 516, 3940-3947 (2008)) relates to the preparation of silicon films containing nanocrystallites and pores suitable for application in thin film transistors. According to Alford et al., an 800 nm layer of amorphous silicon (a-Si) and a 20 nm layer of Al are sequentially deposited on a substrate, so that the Al layer is on top of the a-Si layer. Thermal annealing results in the formation of a thin layer of silicon that contains Si pores and nanocrystallites, which are present in the top 200 nm of the sample, just beneath the Al layer.

US 2013/189575 A1 discloses a porous silicon-based electrode material for use in lithium ion batteries comprising porous crystalline elemental silicon formed by reducing silicon dioxide using a reducing metal in a heating process, followed by acid etching. The porous silicon-based material formed has an average pore size in the range of 5 nm to 500 nm in diameter.

US 2004/161369 A1 discloses metal-coated nanocrystalline porous silicon substrates usable in apparatus for Raman detection, The porous silicon is produced by etching a silicon substrate with dilute hydrofluoric acid in an electrochemical cell, whereby a pore size of 2 nm to 200 nm can be achieved.

Further, in order to overcome the low coulomb efficiency caused by an unstable inherent solid electrolyte interphase, surface coating to create an artificial passivation layer on Si has proved to be an effective approach. However, many processes such as precipitation and sol-gel methods are prone to create inhomogeneous or thick insulating layers. Most recently, atomic layer deposition (ALD) successfully enabled a conformal Aluminum oxide coating with controllable nanometer thickness, which has been widely regarded as a Li-ion transport layer without serious tradeoff of electronic conductivity in electrode networks (He, Y., Yu, X. Q., Wang, Y. H., Li, H. & Huang, X. J. Alumina-coated patterned amorphous silicon as the anode for a lithium-ion battery with high coulombic efficiency. Adv. Mater. 23, 4938-4941 (2011); Scott, I. D., Jung, Y. S., Cavanagh, A. S., Yan, Y. F., Dillon, A. C., George, S. M. & Lee, S. H. Ultrathin coatings on nano-LiCo02 for Li-ion vehicular applications. Nano Lett. 11, 414-418 (2011)). However, simple and low-cost methods for surface coating of semiconductor layers are still lacking.

Object of the invention is to provide a method for producing a porous nanocrystalline semiconductor layer and a porous nanocrystalline semiconductor layer obtained thereby.

This object is achieved by a method for producing a porous nanocrystalline semiconductor layer according to claim 1, a porous nanocrystalline semiconductor layer according to claim 8, a use of the porous nanocrystalline semiconductor layer according to claim 12, an anode according to claim 13, and a secondary lithium-ion battery according to claim 14.

In a first embodiment of the invention, a method for producing a porous nanocrystalline semiconductor layer is provided, including: a) providing a substrate having a substrate surface; b) coating a semiconductor layer on the substrate surface; c) coating a metal containing layer on the semiconductor layer; d) heat treating the semiconductor layer and the metal containing layer at a temperature and for a time period such that the semiconductor layer and the metal containing layer partially interdiffuse and the semiconductor is at least partially crystallized; and e) at least partially removing the metal.

According to a second embodiment, a porous nanocrystalline semiconductor layer is provided, obtainable or obtained by a method of any of the preceding claims, wherein the semiconductor layer is provided on a substrate and includes an outer surface and macropores extending from the outer surface of the semiconductor layer towards the substrate, and wherein the macropores have a depth of 600 to 2100 nm.

A third embodiment provides a use of a porous nanocrystalline semiconductor layer according to the first embodiment in an electrode and/or in an anode for an energy storage device or for a secondary lithium-ion battery.

A fourth embodiment is directed to an anode for a secondary lithium-ion battery, including the porous nanocrystalline semiconductor layer according to the second embodiment.

In a fifth embodiment, a secondary lithium-ion battery including an anode according to the fourth embodiment is provided.

Surprisingly, embodiments of the method according to the invention allow for a metal-induced crystallization of partially miscible or immiscible metal/semiconductor systems, e.g. Si/Al bilayers, to prepare semiconductur films having a thickness of e.g. > 300 nm, in particular ≥ 1 pm, and including a high density of macropores. This method furthermore brings about low temperature crystallization of an initial amorphous semiconductor, including a post-deposition pore-creating. Optionally, a coating of metal oxide, preferably conformal to the semiconductor layer and/or ion-conductive, to enhance the Li transport kinetics of bulk and interface is provided. Both highly satisfactory capacity retention (e.g. about 1650 mAh/g after 500 cycles) and rate performance (e.g. about 1000 mAh/g at 8C) are achieved for anodes according to embodiments of the invention, which include the nanocrystalline semiconductor layers of embodiments. The method of embodiments of the invention can be used to prepare porous nanocrystalline semiconductor layers with well-defined nanostructures, but free of extra binder and conductive additives. Thereby, a much higher area specific capacity of an anode can be achieved than by methods providing inactive-component contained slurry samples and thin film samples. In addition, the method can be performed using linear processing tools and/or continuous substrates.

While the foregoing and the following is directed to examples and embodiments of the invention, other and further embodiments of the invention may be devised. Especially, mutually non-exclusive features of the examples and embodiments of the invention may be combined with each other. Some of the above mentioned embodiments will be described in more detail in the following description of typical embodiments with reference to the following drawings in which:
- Figs. 1a to 1f: schematically illustrate steps c) to e) of the method according to embodiments of the invention;
- Fig. 2: schematically illustrates an embodiment of the semiconductor layer;
- Fig. 3a: shows a surface SEM image of example 1;
- Fig. 3b: shows a cross-sectional FIB image of example 1;
- Fig. 4a: shows a surface SEM image of example 2;
- Fig. 4b: shows a cross-sectional FIB image of example 2;
- Fig. 5a: shows a surface SEM image of example 3;
- Fig. 5b: shows a cross-sectional FIB image of example 3;
- Fig. 6a: shows an XRD pattern of an a-Si (amorphous Si) layer on a Ti substrate of example 2;
- Fig. 6b: shows an XRD pattern of an Al/Si bilayer on the Ti substrate after anneal at 450°C for 30 min of example 2;
- Fig. 6c: shows an XRD pattern of the Si layer of example 2 after annealing and Al etching;
- Fig. 7: shows XPS spectra of the surface composition of example 2, compared with those at the subsurface (20 nm deep from the surface);
- Fig. 8a: shows an XRD pattern of an a-Si coated Ti substrate of example 3;
- Fig. 8b: shows an XRD pattern of an Al coated a-Si layer on the Ti substrate of example 3;
- Fig. 8c: shows an XRD pattern of the Si layer of example 3 after annealing at 600°C for 30 min;
- Fig. 8d: shows an XRD pattern of the Si layer of example 3 after etching for 30 min;
- Fig. 9: shows a charge capacity as a function of cycle number at 0.5 C of example 2 and the a-Si layer on a Ti substrate of comparative example 1; and
- Fig. 10: shows a charge capacity as a function of cycle number at 0.5 to 8 C of example 2.

Within the following description of the drawings, the same reference numbers refer to the same components. Generally, only the differences with respect to the individual embodiments are described. In the following description, embodiments of the invention are described referring to examples wherein Si is used as semiconductor and Al is used as metal, but are not restricted thereto. In addition, the description of different parameter ranges for one parameter, the different parameter ranges each including upper and lower range boundaries, encompasses disclosure of any combination of upper and lower range boundaries of different ranges.

In embodiments of the invention, the term "porous" or "pore" may be understood as at least including macropores. In the context of the invention, macropores may be pores having a pore size, i.e. at least a width and/or a depth, of more than about 50 nm. However, the semiconductor layer of embodiments may also include mesopores and/or micropores, i.e. pores equal to or smaller than about 50 nm. Further, in the following description the terms layer and film are used synonymously.

Further, according to embodiments, the term "nanocrystalline" may be understood as at least including crystalline zones having a width of at least about 1 nm, preferably at least about 5 nm, more preferably of at least about 10 nm, for instance of about 1 nm to 30 nm. The nanocrystalline zones may be as large as the surface structures 106, e.g. each of the surface structures may be single crystalline. The crystalline nature may for instance be derived from XRD (X-Ray Diffraction).

In one embodiment of the invention, a method for producing a porous nanocrystalline semiconductor layer is provided, including: a) providing a substrate having a substrate surface; b) coating a semiconductor layer on the substrate surface; c) coating a metal containing layer on the semiconductor layer; d) heat treating the semiconductor layer and the metal containing layer at a temperature and for a time period such that the semiconductor layer and the metal containing layer partially interdiffuse and the semiconductor is at least partially crystallized; and e) at least partially removing the metal. In step e) the metal may be at least partially removed from the heat treated coated substrate. Further, in step e) the metal may be at least partially removed by etching the heat treated coated substrate.

Embodiments of the invention surprisingly provide a nano-engineering method for forming a porous semiconductor layer, based on incomplete layer exchange and phase separation between metal and semiconductor phases, based on metal-induced crystallization and layer exchange in semiconductor/metal bilayers.

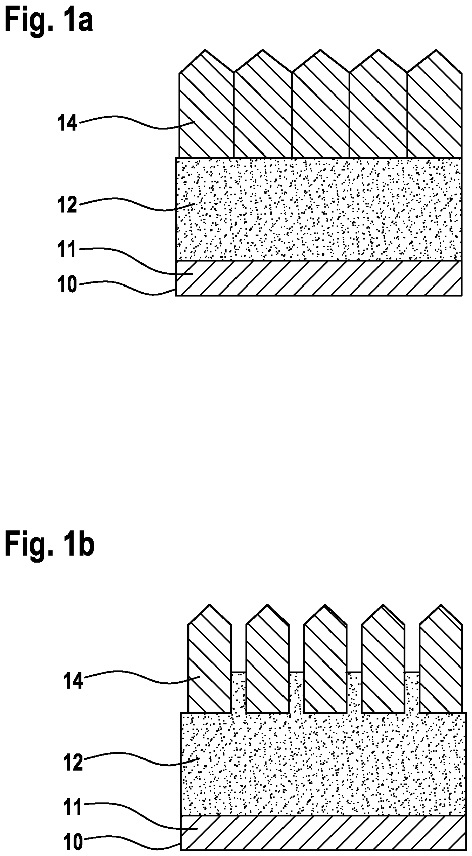

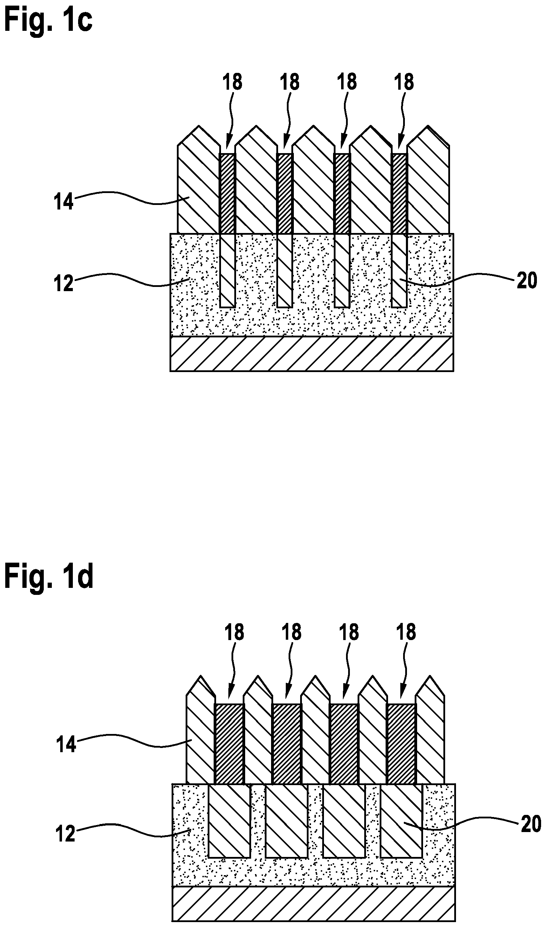

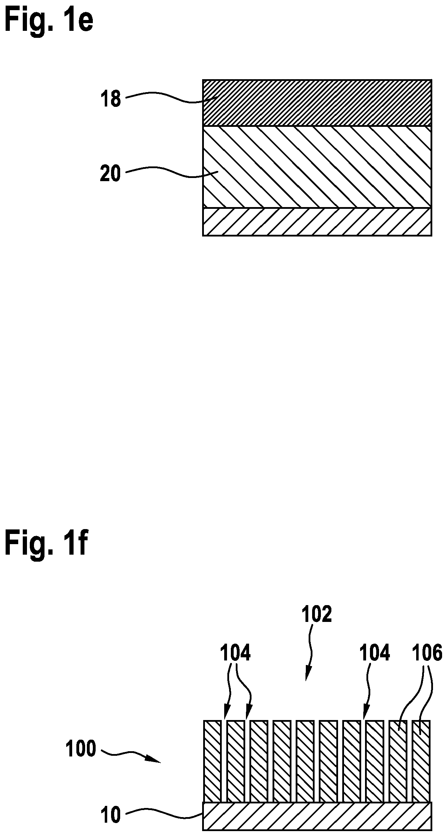

Figs. 1a to If schematically illustrate steps c) to e) of embodiments of the method. It is shown the formation of the nanocrystalline porous semiconductor layer of embodiments by heat treatment, also referred to herein as annealing, and etching. This process starts in Fig. 1a from a bilayer of a metal 14 and an amorphous semiconductor 12 formed on a substrate surface 11 of a substrate 10. Due to the heat treatment, the grain boundaries of the metal are wetted and split by amorphous semiconductor as shown in Fig. 1b. Fig. 1c illustrates the crystallization of amorphous semiconductor and crystalline semiconductor growth at the metal grain boundaries. As can be seen from Fig. 1d, the metal partially diffuses downwards into the original amorphous semiconductor, leading to secondary crystallization of semiconductor therein. Fig. 1e illustrates the metal-induced layer exchange at the end of the heat treatment. Finally, as shown in Fig. If, the metal is etched off, leaving behind a structured porous nanocrystalline semiconductor layer 100.

Before step a) of the method according to embodiments, the substrate may be cleaned, for instance washed using distilled water and/or ethanol, e.g. in an ultrasonic bath. The substrate may also be cleaned, in order to remove surface impurities and/or undesired oxidic layers, e.g. by chemical and/or physical cleaning, such as etching or sputtering.

In some embodiments of the invention, the semiconductor includes one or more semiconductors of Group IV A of the periodic table, in particular Si and/or Ge. Further, the metal and the semiconductor may be partially miscible or immiscible. The term "partially miscible or immiscible" may be understood in the context of the invention that undesired alloying of the metal and the semiconductor can be avoided due to phase separation. For instance, the semiconductor may be soluble in Al metal in an amount of up to 1.6 wt.-% at the eutectic temperature thereof and/or the metal may be soluble in the semiconductor in a molar fraction of up to 4 x 10⁻⁴ at 1450 K.

In embodiments, the metal may include at least one metal soluble in acidic solution and/or in alkaline solution. Moreover, the metal may include at least one metal chosen from Al, Sn, Zn, Ga, In, Pb and Tl. Further, the metal containing layer may include a mixture or alloy of at least one metal and/or at least one semimetal, such as AlGe or AlIn. The metal containing layer may include at least one element chosen from Al, Sn, Zn, Ga, In, Pb, Tl, and Ge. In step e) of the method of embodiments, at least the metal may be at least partially removed. In a modification of step e) the mixture or alloy of metal and/or semimetal may be at least partially removed. In addition, the oxidic layer of the metal may be ion-conductive, thereby promoting use of the produced semiconductor layer in a lithium-ion battery. Moreover, the oxidic layer of the metal may be formed conformal to the porous nanocrystalline semiconductor layer, e.g. the oxidic layer of the metal may cover substantially the whole surface of the porous nanocrystalline semiconductor layer.

According to embodiments of the invention, the substrate and/or the substrate surface may be electrically conductive, e.g. electron-conductive. Further, the substrate is preferably chosen to not provide undesired effects with respect to the applications of the semiconductor layer, e.g. to not disturb battery functions. In further embodiments, the substrate and/or the substrate surface can be chosen from Ti, Ni, Cu, Cr, stainless steel, an electrically conductive polymer, e.g. a polypyrrole or a polyimide, such as Kapton® 200RS100 of DuPont™, an electrically conductive ceramic, such as InSn oxide, or a mixture thereof. The composition of the substrate, which may also be referred to as support, depends on the desired application of the semiconductor layer produced thereon. If the semiconductor layer is formed to be used in an anode of an energy storage device, the substrate may be chosen to be electrically conductive. Alternatively, an electrically non-conductive core coated with an electrically conductive layer can be used as the substrate. The core may include ceramics, such as TiN, TaN, or polymers, e.g. a polyurethane, and the electrically conductive layer may be formed of a metal or of an electron-conductive semiconductor layer or of an electrically conductive ceramic, e.g. InSn oxide. The materials of the support may be formed of a single crystal, or may be polycrystalline or amorphous.

In the method of embodiments, in step b) an amorphous semiconductor layer can be formed. For instance, according to a preferred embodiment, in step b) a semiconductor layer having a thickness of more than 300 nm, in particular 300 nm to 5 pm, preferably 800 nm to 2.5 pm, more preferably 1 to 2 µm can be formed.

Moreover, step c) is performed after step b) such that the metal containing layer is formed on the semiconductor layer. The thickness of each of the metal containing layer and/or of the semiconductor layer may be varied from 100 nm to 1.0 pm, or up to several pm, such as 5 to 20 µm.

According to some examples of the method according to the invention at least one of the coating steps b) and c) includes physical vapour deposition and/or chemical vapour deposition. As a physical vapour deposition process, sputtering, thermal evaporation or molecular beam epitaxy may be chosen. Examples of suitable chemical vapour deposition (CVD) processes include Low Pressure CVD (LPCVD), Plasma-Enhanced CVD (PECVD), Electron Beam CVD (EBCVD), Hot-Wire CVD (HWCVD), and Atmospheric Pressure CVD (APCVD).

In further embodiments of the method, after step c) and before step d), the coatings of steps b) and c) may be repeated one or more times, such that one or more bilayers of the semiconductor layer and of the metal containing layer are coated on the metal containing layer. Thereby, a multilayered structure is obtained instead of a bilayer structure. These embodiments allow for obtaining a semiconductor layer having a higher thickness, e.g. more than 20 pm, and/or for reducing heat treatment time period.

Further, in step d) the temperature and the time period may be chosen such that the crystallized semiconductor 18 is formed on the interdiffused layer 20 including crystallized semiconductor and the metal. For instance, in step d) the heat treating is performed at a temperature of 160 to 650 °C, and/or for a time period of 0.15 to 72 h, preferably 400 to 500 °C for a time period of 15 min to 3h. The relationship of temperature (T) [°C] and time period (t) [min] may follow at least 1/T being proportional to log t, within ± 20%. The relationship of temperature (T) [°C] and time period (t) [min] preferably may be 1/T being proportional to log t, within ± 20%.

Moreover, in step d) of embodiments of the method, the heat treating may be performed at a temperature below the eutectic temperature of the semiconductor and metal combination or at a temperature above the eutectic temperature of the semiconductor and metal combination. For instance as mentioned above, in step d) the heat treating can be performed at a temperature of 160 to 650 °C and/or for a time period of 0.15 to 72 h. Preferably, the heat treatment is performed at temperatures of 180 to 600 °C, more preferably 400 to 500 °C. The heat treatment can be carried out in an oven, which may be a process chamber used in a continuous process performed in subsequent process chambers. Alternatively, for the heat treatment a separate oven can be used, into which the coated substrate is transferred. In some embodiments, the time period for the heat treatment is preferably 0.3 to 60 h, more preferred 0.5 to 20 h, preferably 0.5 h to 1 h. Further, the time period for cooling of the coated substrate may be included in the time period for the heat treatment.

According to some embodiments, in step d) of the method the heat treating is performed in a protective gas atmosphere and/or in vacuum, for instance, at pressures < 10⁻⁴ mbar.

In addition, in step e) of the method, for at least partially removing the metal, the heat treated coated substrate may be etched by an acidic solution and/or an alkaline solution, such as NaOH, KOH, and Ca(OH)₂.

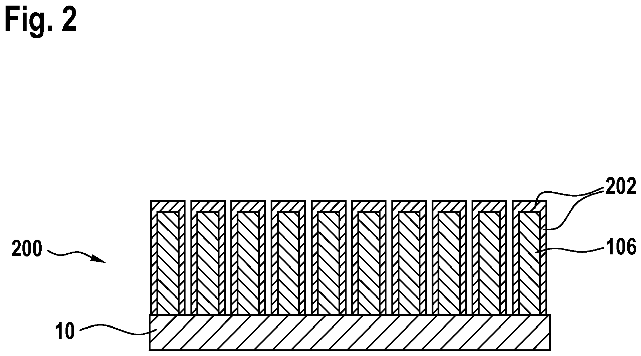

Moreover, in step e) an oxidic layer 202 of the metal can be formed on the porous nanocrystalline semiconductor layer, as shown in Fig. 2, in particular when the heat treated coated substrate is etched by an alkaline solution. The oxidic layer 202 may include or substantially consist of a non-stoichiometric oxide and/or a stoichiometric oxide of the metal. Further, the oxidic layer 202 may include or substantially consist of a mixed metal oxide of the metal and another metal or semimetal. The oxidic layer 202 is preferably formed, when the initial metal containing layer has a thickness of several nanometers to several micrometers, such as ≥ 1 pm, preferably 1 to 5 µm. In a modification of the method, in a step f) after step e) top and/or loose semiconductor material may be at least partially removed, for instance by washing using distilled water and drying using Ar gas or compressed air.

Further, steps a) to f) or at least steps a) to c) may be performed by a continuous process conveying the substrate through subsequent process chambers, which may be provided as linear processing tools.

One embodiment of the method according to the invention is a procedure to construct a porous nanocrystalline Si layer from an Al/Si bilayer. An example of this embodiment to fabricate a Si film with nano-structured morphology is described with reference to the scheme of Fig. 1. The initial Si/Al bilayer (Fig. 1a), the Al layer on top, each layer with a thickness of e.g. 1.5 pm, is sputtered on a polished Ti foil substrate at room temperature in a high-vacuum multi-target sputtering system. A distinct interface between the Si and Al layers is formed. The Si surface is smooth and without typical linear corrugations due to grain boundaries (GBs), in accordance with the amorphous state. The Al layer on top of the Si layer has a typical polycrystalline microstructure with GBs and grain sizes of e.g. 300 to 800 nm in the direction parallel to the surface. Then the bilayer sample is annealed in a vacuum < 10⁻⁴ mbar at a temperature below the eutectic temperature, e.g. 450 °C for 30 min.

During annealing Si diffuses upwards into the Al layer, likely along the Al GBs and has partly formed an additional layer (Fig. 1b). The Al is accordingly squeezed downwards into the original a-Si layer. This intermixing proceeds until Si- and Al-layers are exchanged to a certain extent (Figs. 1c and 1d). Part of the Si diffuses to the top of the specimen forming a discontinuous top crystalline Si layer 18 (Fig. 1e). After annealing the a-Si has turned crystalline. It is noted that solid phase crystallization of pure a-Si normally occurs at a temperature of about 700°C or higher. Due to the final etching by alkali wash, e.g. using NaOH solution, the Al is at least partially removed (Fig. 1f). In addition, the top crystalline Si layer may also be removed, leaving the final porous nanocrystalline Si layer on the Ti foil.

It is understandable that upon removing, e.g. etching off, the Al which connects the top crystalline Si with the rest of nanocrystalline Si the adhesion between the lower crystalline Si layer and the top crystalline Si layer is weakened, leading to a facile remove of the top crystalline Si. However, the top crystalline Si can additionally be washed away by flowing distilled water.

A possible mechanism of the above described aluminum-induced Si crystallization and layer exchange process may be as follows, however, the invention is not restricted thereto. Since the covalent bonds in amorphous Silicon (a-Si) are weakened at the interface with the metal Al layer, the interfacial Si atoms can rather easily be released and become highly mobile. Thermodynamically, these 'free' Si atoms can wet the Al grain boundaries (GBs) in the vicinity, because the total interface energy would decrease when a high angle Al GB is replaced by two a-Si/Al interphase boundaries. Thus, Al GBs are split by an a-Si wetting layer, allowing more free Si atoms from a-Si/ Al interface to diffuse along the Al GBs. Crystallization of the a-Si wetting layer can occur upon reaching a critical thickness, thus causing a crystalline Si coverage to form at the Al GBs. In view of the nucleation sites of crystalline Si exclusively at Al GBs or freshly formed crystalline Si/Al interphase boundaries, once this crystalline Si coverage of the Al GB has formed, it provides a diffusional path for further Si atoms from the a-Si layer upwards, where crystallization then progresses towards the upper surface. At the same time the Al is gradually squeezed into the space left in the original a-Si layer or a-Si/Al interface, probably due to a stress gradient developed in the layer system. One can note two coupled diffusion fluxes, one Si upwards leaving vacancies in the a-Si and Al downwards filling these vacancies plus a concentration gradient. This coupled diffusion fluxes may occur with different velocities and lead to an unbalanced mass distribution which causes stress. Al transported to the a-Si layer also serves as initiation sites for the secondary crystallization of Si. These newly formed Al grains or clusters would delay the further upward diffusion of Si. The continuous crystallization of a-Si and the layer exchange result in the appearance of crystalline Si at the top layer and the mixture of crystalline Si, a-Si and Al in the original a-Si layer. Finally, a well-defined architecture made of crystalline porous Si having a nano-structure, e.g. porous nano-columns, is achieved when the surrounding Al is etched and the top crystalline Si layer is removed.

The above mechanism is contemplated for heat treating the semiconductor layer and oxidic layer of the metal at temperatures below eutectic temperature in step d) of the method of embodiments, without restricting the invention thereto. If in step d) of embodiments a temperature above eutectic temperature of the semiconductor and the metal is chosen, it is contemplated that metal drops may be formed in the semiconductor layer, resulting in pores after removing the metal, which may be larger than the ones produced at temperatures below eutectic temperature, without restricting the invention thereto.

A further embodiment of the invention is directed to a porous nanocrystalline semiconductor layer, obtainable or obtained by a method of embodiments of the invention, wherein the semiconductor layer is provided on a substrate and includes an outer surface and macropores extending from the outer surface of the semiconductor layer towards the substrate, and wherein the macropores have a depth of 600 to 2100 nm.

Fig. If schematically illustrates an embodiment of the porous nanocrystalline semiconductor layer according to the invention. On a substrate 10 a semiconductor layer 100 is provided and includes an outer surface 102 and macropores 104 extending from the outer surface of the semiconductor layer towards the substrate 10. Due to the macropores, within the semiconductor layer volume expansion can be effectively accommodated and strain can be alleviated during use of the semiconductor layer in an energy storage device, e.g. during lithiation in an operating lithium-ion battery, while being accessible to electrolyte.

In embodiments, the porous nanocrystalline semiconductor layer may be corrugated. For example, the porous nanocrystalline semiconductor layer may include macropores which may have a pore size, i.e. at least a width or a depth, of more than about 50 nm, preferably at least about 100 nm, more preferably about 50 to 2100 nm, most preferably about 100 to 500 nm. The macropores having a depth of about 600 to 2100 nm in embodiments for instance may have a width of about 50 to 1000 nm. Furthermore, the macropores of the semiconductor layer may be formed by interspaces of surface structures 106. In addition, the surface structures 106 may be crystalline, nanosized, three-dimensional, irregularly shaped and/or at least a part of them may have a column shape. Moreover, the surface structures may have a width of about 100 to 1000 nm, a height of at least about 100, e.g. 100 to 3000 nm, and/or interspaces of about 50 to 2100 nm. Preferably, the surface structures may have a width of about 300 to 700 nm, a height of about 600 to 2100 nm and/or interspaces of about 50 to 1000 nm. The surface structures 106 may be interconnected with each other.

According to further embodiments, the thickness of the semiconductor layer may be more than 300 nm, preferably 300 nm to 5 pm, preferably 800 nm to 2.5 pm, more preferably 1 to 2 µm. Further, the semiconductor layer may have a porosity of about 20 to 60%. In addition, the semiconductor layer may be doped, in order to promote conductivity. For instance, the semiconductor layer may be n-doped, e.g. by including an element of the Group V A of the periodic system, such as P and/or As. Moreover, the semiconductor layer may be p-doped. Such doping can be performed during the coating procedure of step b) of the method according to embodiments.

In embodiments, the semiconductor surface structures 106 may be coated by an oxidic layer 202 of the metal, e.g. as schematically shown in Fig. 2. The oxidic layer may coat at least a part of the surface structures, e.g. at least the top part of the surface structures at the outer surface 102. The oxidic layer of the metal preferably may cover substantially the whole surface of the porous nanocrystalline semiconductor layer 200. The oxidic layer 202 may include or substantially consist of a non-stoichiometric oxide and/or a stoichiometric oxide of the metal. Further, the oxidic layer 202 may include or substantially consist of a mixed metal oxide of the metal and another metal or semimetal. The oxidic layer 202 may have a thickness of a few nm, e.g. about 0.1 to 50 nm, preferably 2 to 25 nm, more preferably 5 to 20 nm.

In embodiments, at least some of the surface structures 106 may be interconnected with each other. For instance, at least two of the surface structures 106 shown in Figs. If or 2 may be connected by a bridge of semiconductor provided on the substrate 10. Moreover, also the substrate 10 may be coated by the oxidic layer 202 of the metal between the surface structures 106.

In some embodiments of the invention, the semiconductor includes one or more semiconductors of Group IV A of the periodic table, in particular Si and/or Ge. Further, the metal and the semiconductor may be partially miscible or immiscible. Thereby, undesired alloying can be avoided due to phase separation. Moreover, the metal may include at least one metal chosen from Al, Sn, Zn, Ga, In, Pb and Tl. Further, the oxidic layer may include a mixture of at least one metal and/or at least one semimetal, such as AlGe or AlIn. The oxidic layer may for example include at least one element chosen from Al, Sn, Zn, Ga, In, Pb, Tl, and Ge. In addition, the oxidic layer 202 of the metal may be ion-conductive, thereby promoting use of the produced semiconductor layer in a lithium-ion battery. Moreover, the oxidic layer of the metal may be conformal to the porous nanocrystalline semiconductor layer, e.g. the oxidic layer of the metal may cover substantially the whole surface of the porous nanocrystalline semiconductor layer. According to embodiments of the invention, the substrate and/or the substrate surface may be electrically conductive, e.g. electron-conductive. In further embodiments, the substrate and/or the substrate surface can be chosen from Ti, Ni, Cu, Cr, stainless steel, an electrically conductive polymer, an electrically conductive ceramic or a mixture thereof. The composition of the substrate, which may also be referred to as support, depends on the desired application of the semiconductor layer produced thereon. If the semiconductor layer is formed to be used in an anode of an energy storage device, the substrate may be chosen to be electrically conductive. Alternatively, an electrically non-conductive core coated with an electrically conductive layer can be used as the substrate. The core may include ceramics or polymers and the electrically conductive layer may be formed of a metal or of another electrically conductive material, such as InSn oxide, as mentioned above. The materials of the support may be formed of a single crystal, or may be polycrystalline or amorphous.

A further embodiment of the invention is directed to a use of a porous nanocrystalline semiconductor layer according to any embodiment in an electrode and/or in an anode for an energy storage device or for a secondary lithium-ion battery.

Moreover, a further embodiment provides an anode for a secondary lithium-ion battery, including the porous nanocrystalline semiconductor layer according to any of embodiments of the invention.

In another embodiment a secondary lithium-ion battery including an anode according the preceding embodiment is provided.

An example of a method of fabricating an energy storage device according to embodiments includes: providing an electrically conductive substrate; forming the porous nanocrystalline semiconductor layer of embodiments of the invention on the electrically conductive substrate, the semiconductor layer being a first electrode; providing an electrolyte and a second electrode to form the energy storage device. The substrate may be a continuous film and the electrode(s) of the energy storage device may be fabricated using linear processing tools. The semiconductor may be silicon and the deposition tool may be a thermal spray tool. The energy storage device may be rolled into a cylindrical shape. The energy storage device of embodiments may be a battery, a capacitor or an ultracapacitor.

### Examples

### Experimental Section

### Sample preparation

Pure Titanium foils (99.6%, Goodfellow, 40 x 70 mm², thickness 125 pm) were used in examples 2 and 3 as substrates for growing Si/Al bilayers. The Ti foils were cleaned with ethanol in ultrasonic cleaner to remove organic contaminants on the surface before layer growth. In example 1, a porous foamed circular Ni/Cr substrate (Shanghai Zhonghui Foamed Aluminum Product Co., Ltd.), having a diameter of 10 mm is used (available from website http://en.zhonghuiaf.com /products_detail/&productId=d8daad23-4ca5-4e0a-ae50-6dc52659ac56&comp_stats=comp-FrontProducts_list01-111.html).

The Si/Al bilayer samples were prepared by sequentially sputtering a Si target and an Al target (Kurt J. Lesker; Al: KJLC Part Number EJTALXX502A4; Si: KJLC Part Number EJTPSIX502A4) in a high-vacuum multi-target DC sputtering system. After reaching a background vacuum pressure less than 1 x 10⁻⁷ mbar, the substrates were cleaned with Ar⁺ ions for 1 min. Then a 1500 nm thick Si layer was deposited by using a sputtering power of 100 W in an Ar atmosphere of 5.9-10⁻³ mbar, followed by depositing a 1500 nm or 150 nm thick Al layer at a power of 200 W under the same Ar pressure.

The substrate was kept at room temperature during the layer growth. The deposited Si/ Al samples were then annealed in a vacuum oven at 10⁻⁵ mbar and different temperatures for different times. The temperature was determined in the temperature constant zone of the vacuum oven by a thermocouple. Thus, the determined temperature can be considered as being substantially equal to the temperature of the sample (± 1 °C).

The annealed samples were cooled to room temperature and further etched by 1 mol/L NaOH solution for 15 to 30 min to at least partially remove Al, e.g. at least until no H₂ gas evolution in the etching solution was seen any longer. Finally, the samples were flushed with distilled water and dried with an Ar gas stream.

### Material characterization

To observe the formation process of nanostructured Si thick film samples, their cross-sections at different anneal/etch stages were observed in a focused ion beam (FIB) microscope (FEI FIB200). The surface morphology and microstructure of samples were also observed through the scanning electron microscope (SEM, Carl Zeiss Leo 1530 VP Germini). EBSD, Electron Backscattering Diffraction was performed by an EBSD, Oxford, HKL detector mounted on the SEM setup operated at 15 kV and a cathode beam current of 164 µA. X-ray diffraction (XRD) measurements of the samples were carried out in a Philips X'Pert MRD Pro diffractometer. The surface and subsurface compositions of the etched samples were analyzed by X-ray photoelectron spectroscopy (XPS, Thermo VG, Thetaprobe 300 system) in combination with in situ Ar+ sputter cleaning.

Two-electrode Swagelok-type cells were assembled to include Si layers of embodiments of the invention treated in different ways as working electrodes (anodes) and high-purity lithium foil (Aldrich) as counter electrode, in order to perform the electrochemical measurements. Glass fiber (GF/D) from Whatman was employed as the separator. 1 M LiPF₆ in a non-aqueous mixture of ethylene carbonate (EC) and dimethyl carbonate (DMC) with a volume ratio of 1:1 (Ube Industries Ltd) was used as electrolyte. The cells were assembled in an Ar-filled glove box. Charge-discharge measurements were performed at room temperature under different rates from 0.1C to 8C (1C denotes the current density to theoretically achieve multi-electron reaction to form L₂₂Si₅ phase within 1 h, i.e. to achieve a complete charging of the cells) in a voltage range of 0.01 - 1.5 V on an Arbin MSTAT battery test system.

### Working Examples

In examples 1 to 3 samples were prepared as mentioned above, however using individual layer thicknesses, heating temperatures and heating and etching periods.

### Example 1 (not according to the invention)

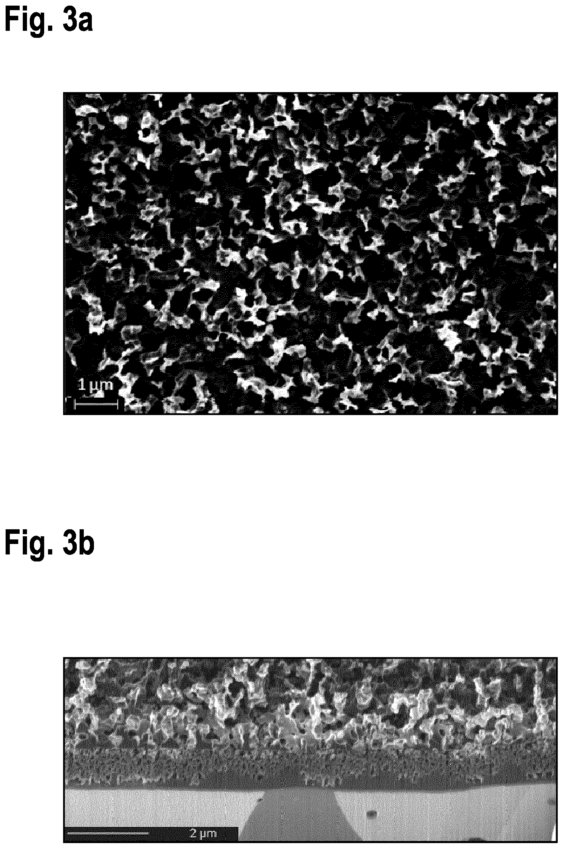

An above mentioned Ni/Cr foam substrate was covered first with a Si layer of a thickness of about 1500 nm. On the Si layer, an Al layer of a thickness of about 1500 nm was deposited. The Si/Al coated substrate was then heated in the vacuum oven at 180 °C for 60 h. Finally, after etching for 15 min until H₂ gas evolution stopped, flushing and drying, an Aluminum oxide covered porous nanocrystalline Si layer including macropores having a pore width and a pore height of up to several hundred nm, e.g. a pore width of up to 500 nm and a pore height of up to 250 nm, was obtained as shown in the surface SEM and cross-sectional FIB images of Figs. 3a and 3b.

### Example 2

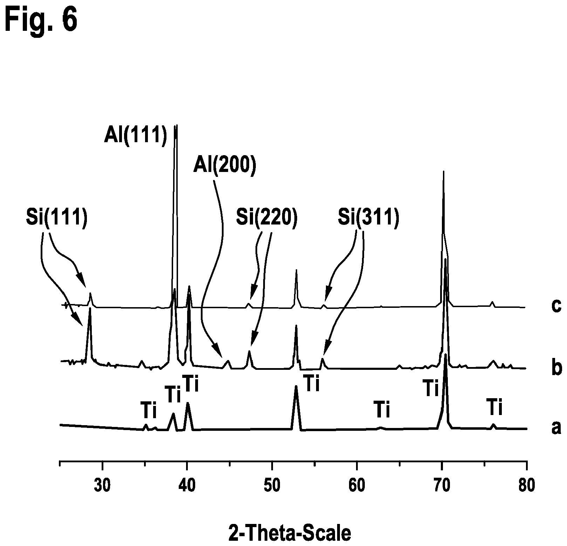

An above mentioned Ti foil substrate was covered first with a Si layer of a thickness of about 1500 nm. On the Si layer, an Al layer of a thickness of about 1500 nm was coated. The Si/Al coated substrate was then heated in the vacuum oven at 450 °C for 0.5 h. Hence, the temperature was below the eutectic temperature of the Si/Al combination, the eutectic temperature being 577 °C. The Al layer on top of the Si layer had a typical polycrystalline microstructure with GBs and grain sizes of 300 to 800 nm (measured by EBSD) in the direction parallel to the surface. Fig. 6a shows an XRD pattern of the a-Si (amorphous Si) layer on the Ti substrate. As can be seen from Fig. 6a only Ti reflexes are present. In Fig. 6, as in each XRD pattern presented herein, the XRD pattern is background subtracted. Further, in Fig. 6 the XRD diffraction peaks of Ti substrate, Al template, and Si active material are labelled, indicating for example 2 a highly textured Al/Si system with a (111) grain orientation prior to etching. In Fig. 6b, the XRD pattern of the Al/Si bilayer on the Ti substrate after anneal at 450°C for 30 min is shown, illustrating the crystalline nature of Si and Al.

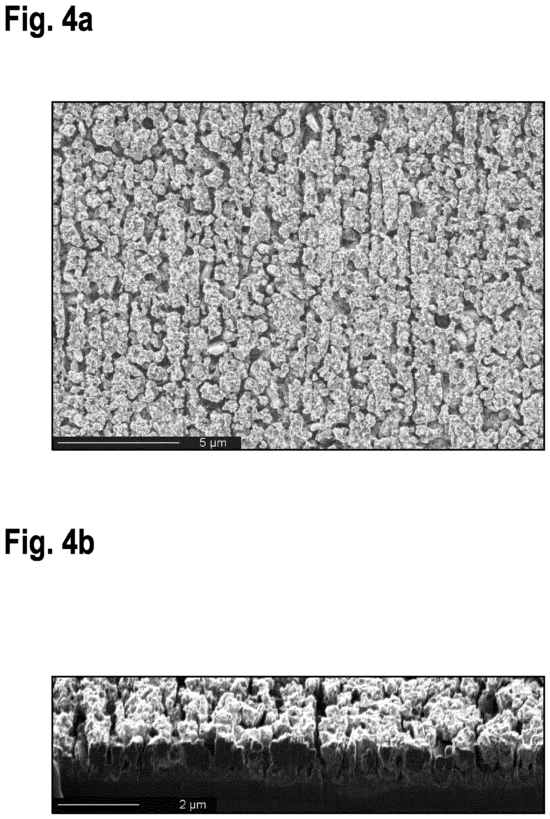

An Aluminum oxide covered porous Si layer was finally obtained after etching for 15 min, as shown in the surface SEM and cross-sectional FIB images of Figs. 4a and 4b. In this example, as can be seen from Figs. 4a and 4b, the macropores of the Si layer are formed as spaces between columnar-type nano-structures, so called nano-columns, the nano-structures having an average width of about 500 nm, an average height of about 1500 nm, and an average inter-column spacing of about 250 nm. Hence, a porous nanocrystalline Si layer including macropores having a pore width and a pore height of up to several hundred nm, e.g. a pore width of up to 250 nm and a pore height of up to 1000 nm, was obtained. The porosity was about 60%, determined by physically counting in the surface SEM image the number of pores per unit surface area and evaluating the results using the "straight line" method.

Fig. 6c shows an XRD pattern of the Si layer of example 2 after annealing and Al etching on the Ti substrate. Fig. 6c illustrates that crystalline Al has disappeared after etching.

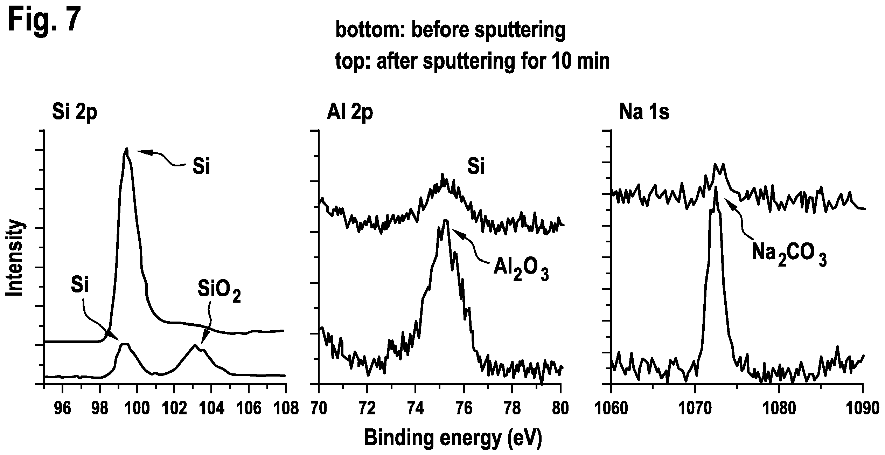

As shown in Fig. 7, X-ray photoelectron spectroscopy (XPS) of Si 2p, Al 2p and Na 1s was used to investigate the surface compositions after annealing and Al etching, which were further compared to those at the subsurface (20 nm deep from the surface) by X 1 keV Ar+ sputtering for 10 min. Apart from Si (99.4 eV) and Si0₂ (103.3 eV, formed by naturally oxidizing surface Si), the signals of Al (75.3 eV) and Na (1072.5 eV) at the surface were also observed. Considering that the analysis depth of XPS is only about 5 nm, this observation indicates the presence of a thin Al oxide coating of about a few nm thickness on the surface. From the reaction with C0₂ it is understandable that small amounts of Aluminum oxide and Na₂C0₃ remain at the surface after NaOH etching and drying in Ar flow. Note that the XPS peak intensities of Al 2p and Na 1s have almost disappeared after Ar+ sputtering, confirming the thin Al oxide coating, which may serve as an artificial solid electrolyte interphase to improve the coulomb efficiency of Si anodes as demonstrated in the electrochemistry discussion below. It is also deducible from Fig. 7 that the Si nano-columns are individually coated by thin Aluminum oxide as long as they are well covered with the diffused Al.

### Example 3

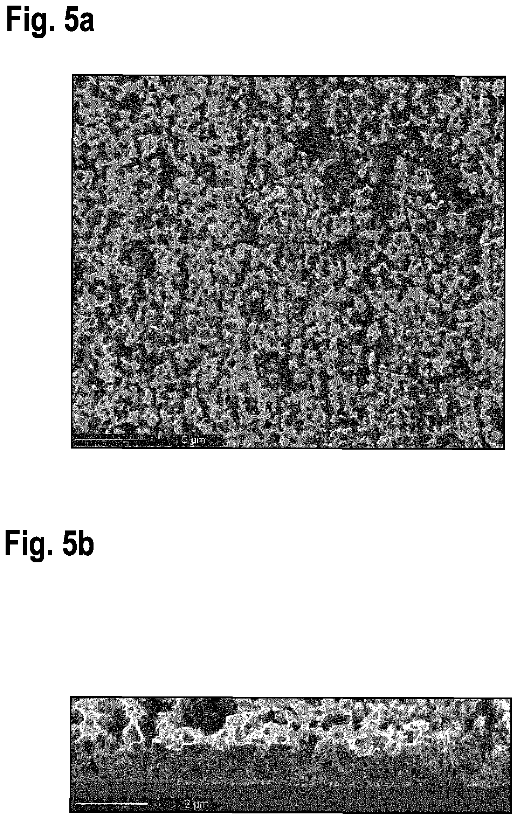

An above mentioned Ti foil substrate was covered first with a Si layer of a thickness of about 1500 nm. On the Si layer, an Al layer of a thickness of about 150 nm was coated. The Si/Al coated substrate was then heated in the vacuum oven at 600 °C for 0.5 h. Hence, the temperature was above the eutectic temperature of the Si/Al combination, the eutectic temperature being 577 °C. A porous nanocrystalline Si layer including macropores having a pore width and a pore height of up to several hundred nm, e.g. a pore width of up to 1000 nm and a pore height of up to 1000 nm, was obtained as shown in the surface SEM and cross-sectional FIB images of Figs. 5a and 5b.

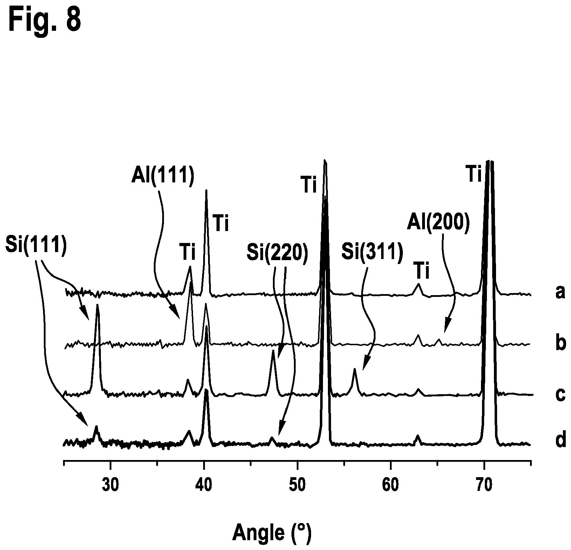

Fig. 8a is an XRD pattern of the a-Si (amorphous Si) coated Ti substrate of example 3. Fig. 8b shows an XRD pattern of the Al coated a-Si layer on the Ti substrate. The XRD pattern of the Si layer of example 3 after annealing for 30 min is shown in Fig. 8c. Fig. 8d shows the XRD pattern of the Si layer after etching the surface for 30 min. It is clear from Fig. 8d, that polycrystalline Si but essentially no Aluminum oxide is present at the surface, the weak diffraction peak of Si indicating that the nanoporous Si framework is at least partially nanocrystalline.

### Comparative Example 1

In comparative example 1, an a-Si and Al bilayer was formed on a Ti foil substrate as described for example 2, however without heating. Finally, an Aluminum oxide coated a-Si layer was obtained.

### Electrochemical Characterization

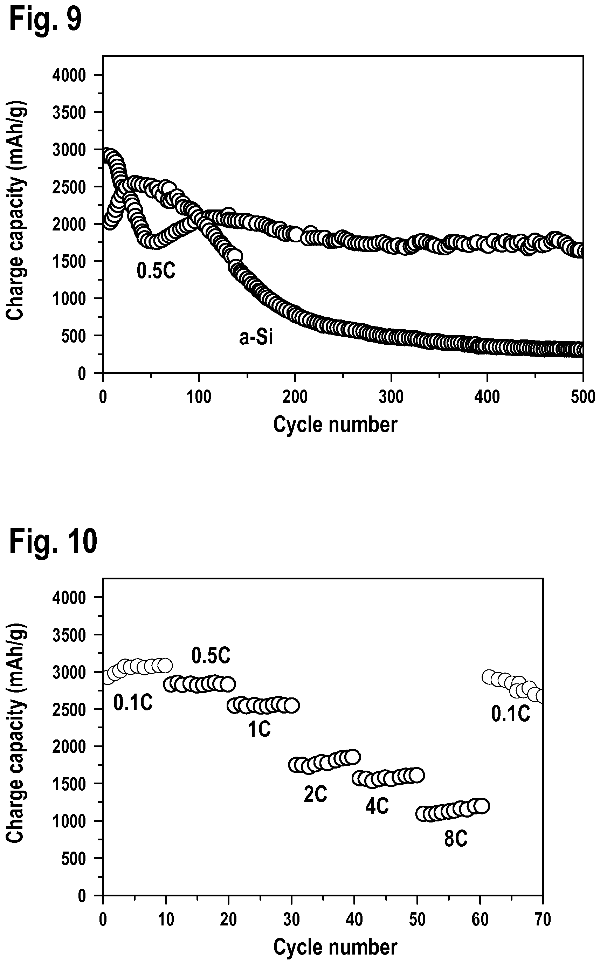

In Figs. 9 and 10, the results of electrochemical measurements using two-electrode Swagelok-type cells containing the layered samples of example 2 and comparative example 1 are shown. In Figs. 9 and 10 the unit C is to be understood in the sense that 1C denotes the current density to theoretically achieve multi-electron reaction to form the L₂₂Si₅ phase within 1 h, i.e. it denotes the charge rate to achieve a complete charging of the cell.

Fig. 9 illustrates the charge capacity of example 2 as a function of cycle number at 0.5 C compared to the charge capacity of comparative example 1, as a life test. One cycle is represented by one circle in Fig. 9. After 500 cycles the capacity of example 2 was at 1650 mAh/g, i.e. at 55 % of the initial capacity of 3000 mAh/g. Although there is an early capacity loss in the first 50 cycles, the capacity is then increased and stabilized at 2000 mAh/g and 1650 mAh/g in the following 150 and 500 cycles, respectively. In contrast thereto, the capacity of comparative example 1 was considerably reduced at 500 cycles. The capacity retention of comparative example 1 fades quickly after 100 cycles and drops to 1260 mAh/g and 280 mAh/g at the 160th and 500th cycle respectively. This clearly shows, that example 2 of the invention provides an improved capacity retention as compared to comparative example 1.

In Fig. 10, the charge capacity as a function of cycle number at 0.1 to 8 C in a continuous test of example 2 is shown. Each cycle encompassed a complete charging from 0.01 V to 1.5 V and a discharging from 1.5 V to 0.01 V and is represented by one circle in Fig. 10. The cycle period at charge rate 0.1 C was 20 h. 10 cycles were performed at each charge rate. As illustrated, the capacity of example 2 is still preserved at about 1800 mAh/g and 1000 mAh/g when the charge rates are as high as 2C and 8C respectively. In contrast thereto, for comparative example 1 a capacity below 1000 mAh/g at 2C was observed (not shown in Fig. 10). Hence, the Si anode according to example 2 results in a much better rate performance than the coated a-Si anode of comparative example 1.

The examples show that embodiments of the invention allow both highly satisfactory capacity retention (e.g. 1650 mAh/g after 500 cycles) and rate performance (e.g. ∼ 1000 mAh/g at 8C), i.e. a superior durability and life period, for electrodes which include the porous nanocrystalline semiconductor layer of embodiments.

### Results Summary

As compared to the production of previous semiconductor anodes including nanoparticles, no binder or additive is required in the method of embodiments of the invention. The method of embodiments of the invention allows, as compared to the production of Nanowires, that no pretreatment of the substrate, e.g. in order to promote seed growth of a second phase of the material, is required. Further, previous semiconductor nano-material was typically manufactured in complicated chemical deposition processes from explosive and toxic gases using HF. However, in the method according to embodiments of the invention such explosive and toxic agents are not utilized.

In the porous nanocrystalline semiconductor layer of embodiments according to the invention, the space between individual nano-sized surface structures, i.e. the macropores, can effectively accommodate volume expansion and alleviate strain during lithiation, while being accessible to electrolyte during operation of a lithium-ion battery.

Therefore, the method of embodiments is not only beneficial as regards facilitated ion/electron transport pathways and networks in electrodes including the semiconductor layer produced, but also with respect to volume/strain accommodation in the semiconductor layer by semiconductor crystallization and nano-engineering.

Further, the method of embodiments according to the invention may provide solid electrolytic interphase (SEI) stabilization and/or coulomb efficiency improvement by nano-structuring the semiconductor layer and by an optional coating of an oxidic layer of the metal, which may be conformal and/or ion-conductive.

Particularly embodiments, in which an oxidic layer of the metal is provided on the semiconductor layer, allow avoiding formation of a solid electrolytic interphase, which may deteriorate the battery capacity during operation of the battery. In addition, the oxidic layer of the metal of embodiments helps to avoid breakage and cracking of the semiconductor layer, to prevent delamination or fracture during lithiation-driven volume expansion. Previously, a thin oxidic layer of the metal has been formed by Atomic Layer Deposition (ALD), which is more complicated, slower and costly than the method of embodiments of the invention. The latter allows forming an oxidic layer of the metal simply during the etching step, e.g. using alkaline solution.

The method of embodiments of the invention provides a unique nano-engineering of e.g. nanocrystalline Si films, having a thickness of for instance > 0.8 µm, as Li-ion battery anodes from amorphous Si (a-Si) films based on aluminum-induced crystallization (AIC) and layer exchange processes in Si/Al bilayers.

In contrast to the preparation of semiconductor nanostructures by metal-catalyzed growth at high temperature, e.g. via vapor-liquid-solid (VLS) mechanism, the method of embodiments allows a growth temperature lower than the eutectic one (for Si/Al: 577 °C) without remarkable solubility and diffusivity in the bulk of the metal. Using this approach for instance nanocrystalline Si films, e.g. as thick as 1.5 pm, with a morphology consisting in a high density of isolated nano-structures having columnar shapes can be produced.

Furthermore, the method of embodiments allows not only a low-temperature crystallization of originally amorphous Si, but may also provide an optional coating of Aluminum oxide which can be generated on almost each Si nano-sized surface structure by facile oxidization of residual Al on Si surfaces during an alkali wash.

The nano-engineered Si layers of embodiments of the invention are beneficial to the Li-storage kinetics, for instance by a reversible capacity as large as about 1650 mAh/g with a about 99% coulomb efficiency still after an extremely long cycling of 500 times.

## Claims

1. A method for producing a porous nanocrystalline semiconductor layer, comprising
a) providing a substrate (10) having a substrate surface (11);
b) coating a semiconductor layer (12) on the substrate surface;
c) coating a metal containing layer (14) on the semiconductor layer;
d) heat treating the semiconductor layer and the metal containing layer at a temperature (T) and for a time period (t) such that the semiconductor layer and the metal containing layer partially interdiffuse and the semiconductor is at least partially crystallized; and
e) at least partially removing the metal.

2. The method of claim 1,
wherein in step b) an amorphous semiconductor layer (12) is formed; and/or
wherein in step d) the temperature and the time period are chosen such that crystallized semiconductor (18) is formed on an interdiffused layer (20) including crystallized semiconductor and the metal; and/or
wherein in step e) the metal is at least partially removed by etching the heat treated coated substrate; and/or
wherein in step e) an oxidic layer (202) of the metal is formed on the porous nanocrystalline semiconductor layer (200); and/or
wherein after step e) in a step f) top and/or loose semiconductor material is removed.

3. The method of any of the preceding claims,
wherein the semiconductor includes one or more semiconductors of Group IV A of the periodic table; and/or
wherein the semiconductor includes Si and/or Ge; and/or wherein the metal and the semiconductor are partially miscible or immiscible; and/or
wherein the metal includes at least one metal soluble in acidic solution and/or in alkaline solution; and/or wherein the metal includes at least one metal chosen from Al, Sn, Zn, Ga, In, Pb and Tl; and/or
wherein the metal containing layer includes at least one element chosen from Al, Sn, Zn, Ga, In, Pb, Tl, and Ge; and/or
wherein the oxidic layer of the metal is ion-conductive; and/or
wherein the oxidic layer of the metal is formed conformal to the porous nanocrystalline semiconductor layer.

4. The method of any of the preceding claims,
wherein the substrate and/or the substrate surface is electrically conductive; and/or
wherein the substrate and/or the substrate surface is chosen from Ti, Ni, Cu, Cr, stainless steel, an electrically conductive polymer, an electrically conductive ceramic, or a mixture thereof.

5. The method of any of the preceding claims,
wherein at least one of the coating steps b) and c) includes physical vapour deposition, chemical vapour deposition,; and/or
wherein steps a) to f) or at least steps a) to c) are performed by a continuous process conveying the substrate through subsequent process chambers; and/or
wherein in step b) a semiconductor layer having a thickness of more than 300 nm, preferably 300 nm to 5 µm is formed.

6. The method of any of the preceding claims,
wherein after step c) and before step d) one or more bilayers of the semiconductor layer and of the metal containing layer are coated on the metal containing layer; and/or
wherein in step d) the heat treating is performed at a temperature below the eutectic temperature of the semiconductor and metal combination or at a temperature above the eutectic temperature of the semiconductor and metal combination; and/or
wherein the relationship of temperature (T) [°C] and time period (t) [min] follows at least 1/T being proportional to log t; and/or
wherein in step d) the heat treating is performed at a temperature of 160 to 650 °C and/or for a time period of 0.15 to 72 h.

7. The method of any of the preceding claims,
wherein in step d) the heat treating is performed in a protective gas atmosphere and/or in vacuum; and/or
wherein in step e) the heat treated coated substrate is etched by an acidic solution and/or an alkaline solution.

8. A porous nanocrystalline semiconductor layer, obtainable or obtained by a method of any of the preceding claims,
wherein the semiconductor layer (100; 200) is provided on a substrate (10) and includes an outer surface (102) and macropores (104) extending from the outer surface of the semiconductor layer towards the substrate (10), and
wherein the macropores have a depth of 600 to 2100 nm.

9. The semiconductor layer of claim 8,
wherein the macropores have a pore size of more than 50 nm; and/or
wherein the macropores have a width of 50 to 1000 nm; and/or
wherein the macropores of the semiconductor layer are formed by interspaces of surface structures (106); and/or wherein the surface structures are crystalline, nanosized, three-dimensional, irregularly shaped and/or have a column shape; and/or
wherein the surface structures have a width of 100 to 1000 nm, a height of 100 to 3000 nm and/or interspaces of 50 to 2100 nm.

10. The semiconductor layer of claim 8 or 9,
wherein the thickness of the semiconductor layer is more than 300 nm, preferably 300 nm to 5 pm; and/or
wherein the semiconductor surface structures (106) are coated by an oxidic layer (202) of the metal.

11. The semiconductor layer of any of claims 8 to 10,
wherein the semiconductor includes one or more semiconductors of Group IV A of the periodic table; and/or
wherein the semiconductor includes Si and/or Ge; and/or wherein the metal and the semiconductor are partially miscible or immiscible; and/or
wherein the metal includes at least one metal soluble in acidic solution and/or in alkaline solution; and/or wherein the metal includes at least one metal chosen from Al, Sn, Zn, Ga, In, Pb and Tl; and/or
wherein the oxidic layer includes at least one element chosen from Al, Sn, Zn, Ga, In, Pb, Tl, and Ge; and/or wherein the substrate and/or the substrate surface is electrically conductive; and/or
wherein the substrate and/or the substrate surface is chosen from Ti, Ni, Cu, Cr, stainless steel, an electrically conductive polymer, an electrically conductive ceramic, or a mixture thereof; and/or
wherein the oxidic layer of the metal is ion-conductive and/or conformal to the porous nanocrystalline semiconductor layer.

12. A use of a porous nanocrystalline semiconductor layer according to one of claims 8 to 11 in an electrode and/or in an anode for an energy storage device or for a secondary lithium-ion battery.

13. An anode for a secondary lithium-ion battery, comprising the porous nanocrystalline semiconductor layer according to one of claims 8 to 11.

14. A secondary lithium-ion battery comprising an anode according to claim 13.

## Patentansprüche

1. Verfahren zur Herstellung einer porösen nanokristallinen Halbleiterschicht, umfassend
a) Bereitstellen eines Substrats (10) mit einer Substratoberfläche (11);
b) Beschichten der Substratoberfläche mit einer Halbleiterschicht (12);
c) Beschichten der Halbleiterschicht mit einer metallhaltigen Schicht (14);
d) Wärmebehandlung der Halbleiterschicht und der metallhaltigen Schicht bei einer Temperatur (T) und für eine Zeitdauer (t), so dass die Halbleiterschicht und die metallhaltige Schicht teilweise interdiffundieren und der Halbleiter zumindest teilweise kristallisiert ist; und
e) zumindest teilweise Entfernen des Metalls.

2. Verfahren nach Anspruch 1,
wobei in Schritt b) eine amorphe Halbleiterschicht (12) ausgebildet wird; und/oder
wobei in Schritt d) die Temperatur und die Zeitdauer so gewählt werden, dass kristallisierter Halbleiter (18) auf einer interdiffundierten Schicht (20), die kristallisierten Halbleiter und das Metall enthält, ausgebildet wird; und/oder
wobei in Schritt e) das Metall zumindest teilweise durch Ätzen des wärmebehandelten beschichteten Substrats entfernt wird; und/oder
wobei in Schritt e) eine Oxidschicht (202) des Metalls auf der porösen nanokristallinen Halbleiterschicht (200) ausgebildet wird; und/oder
wobei nach Schritt e) in einem Schritt f) oberes und/oder loses Halbleitermaterial entfernt wird.

3. Verfahren nach einem der vorhergehenden Ansprüche,
wobei der Halbleiter einen oder mehrere Halbleiter der Gruppe IV A des Periodensystems enthält; und/oder
wobei der Halbleiter Si und/oder Ge enthält; und/oder
wobei das Metall und der Halbleiter teilweise mischbar oder nicht mischbar sind; und/oder wobei das Metall mindestens ein in saurer Lösung und/oder in alkalischer Lösung lösliches Metall enthält; und/oder
wobei das Metall mindestens ein Metall enthält, das ausgewählt ist aus Al, Sn, Zn, Ga, In, Pb und Tl; und/oder
wobei die metallhaltige Schicht mindestens ein Element enthält, das ausgewählt ist aus Al, Sn, Zn, Ga, In, Pb, Tl und Ge; und/oder
wobei die Oxidschicht des Metalls ionenleitend ist; und/oder
wobei die Oxidschicht des Metalls konform zur porösen nanokristallinen Halbleiterschicht ausgebildet wird.

4. Verfahren nach einem der vorhergehenden Ansprüche,
wobei das Substrat und/oder die Substratoberfläche elektrisch leitfähig ist; und/oder
wobei das Substrat und/oder die Substratoberfläche ausgewählt ist aus Ti, Ni, Cu, Cr, Edelstahl, einem elektrisch leitfähigen Polymer, einer elektrisch leitfähigen Keramik oder einer Mischung davon.

5. Verfahren nach einem der vorhergehenden Ansprüche,
wobei mindestens einer der Beschichtungsschritte b) und c) eine physikalische Dampfabscheidung, eine chemische Dampfabscheidung enthält; und/oder
wobei die Schritte a) bis f) oder mindestens die Schritte a) bis c) durch einen kontinuierlichen Prozess durchgeführt werden, der das Substrat durch nachfolgende Prozesskammern fördert; und/oder
wobei in Schritt b) eine Halbleiterschicht mit einer Dicke von mehr als 300 nm, vorzugsweise 300 nm bis 5 µm, ausgebildet wird.

6. Verfahren nach einem der vorhergehenden Ansprüche,
wobei nach Schritt c) und vor Schritt d) eine oder mehrere Doppelschichten der Halbleiterschicht und der metallhaltigen Schicht auf die metallhaltige Schicht aufgebracht werden; und/oder
wobei in Schritt d) die Wärmebehandlung bei einer Temperatur unterhalb der eutektischen Temperatur der Halbleiter-Metall-Kombination oder bei einer Temperatur oberhalb der eutektischen Temperatur der Halbleiter-Metall-Kombination durchgeführt wird; und/oder
wobei das Verhältnis von Temperatur (T) [°C] und Zeitdauer (t) [min] zumindest "1/T ist proportional zu log t" folgt; und/oder
wobei in Schritt d) die Wärmebehandlung bei einer Temperatur von 160 bis 650 °C und/oder für eine Zeitdauer von 0,15 bis 72 h durchgeführt wird.

7. Verfahren nach einem der vorhergehenden Ansprüche,
wobei in Schritt d) die Wärmebehandlung in einer Schutzgasatmosphäre und/oder im Vakuum durchgeführt wird; und/oder
wobei in Schritt e) das wärmebehandelte beschichtete Substrat durch eine saure Lösung und/oder eine alkalische Lösung geätzt wird.

8. Poröse nanokristalline Halbleiterschicht, erhältlich oder erhalten durch ein Verfahren nach einem der vorhergehenden Ansprüche,
wobei die Halbleiterschicht (100; 200) auf einem Substrat (10) aufgebracht ist und eine Außenfläche (102) und Makroporen (104), die sich von der Außenfläche der Halbleiterschicht zu dem Substrat (10) erstrecken, enthält, und
wobei die Makroporen eine Tiefe von 600 bis 2100 nm aufweisen.

9. Halbleiterschicht nach Anspruch 8,
wobei die Makroporen eine Porengröße von mehr als 50 nm aufweisen; und/oder
wobei die Makroporen eine Breite von 50 bis 1000 nm aufweisen; und/oder
wobei die Makroporen der Halbleiterschicht durch Zwischenräume von Oberflächenstrukturen (106) ausgebildet werden; und/oder
wobei die Oberflächenstrukturen kristallin, nanometergroß, dreidimensional, unregelmäßig geformt sind und/oder eine Säulenform aufweisen; und/oder
wobei die Oberflächenstrukturen eine Breite von 100 bis 1000 nm, eine Höhe von 100 bis 3000 nm und/oder Zwischenräume von 50 bis 2100 nm aufweisen.

10. Halbleiterschicht nach Anspruch 8 oder 9,
wobei die Dicke der Halbleiterschicht mehr als 300 nm, vorzugsweise 300 nm bis 5 µm beträgt; und/oder
wobei die Halbleiteroberflächenstrukturen (106) mit einer Oxidschicht (202) des Metalls beschichtet sind.

11. Halbleiterschicht nach einem der Ansprüche 8 bis 10,
wobei der Halbleiter einen oder mehrere Halbleiter der Gruppe IV A des Periodensystems enthält; und/oder
wobei der Halbleiter Si und/oder Ge enthält; und/oder
wobei das Metall und der Halbleiter teilweise mischbar oder nicht mischbar sind; und/oder
wobei das Metall mindestens ein in saurer Lösung und/oder in alkalischer Lösung lösliches Metall enthält; und/oder
wobei das Metall mindestens ein Metall enthält, das ausgewählt ist aus Al, Sn, Zn, Ga, In, Pb und Tl; und/oder
wobei die Oxidschicht mindestens ein Element enthält, das ausgewählt ist aus Al, Sn, Zn, Ga, In, Pb, Tl und Ge; und/oder
wobei das Substrat und/oder die Substratoberfläche elektrisch leitfähig ist; und/oder
wobei das Substrat und/oder die Substratoberfläche ausgewählt ist aus Ti, Ni, Cu, Cr, Edelstahl, einem elektrisch leitfähigen Polymer, einer elektrisch leitfähigen Keramik oder einer Mischung davon; und/oder
wobei die Oxidschicht des Metalls ionenleitend und/oder konform zur porösen nanokristallinen Halbleiterschicht ist.

12. Verwendung einer porösen nanokristallinen Halbleiterschicht nach einem der Ansprüche 8 bis 11 in einer Elektrode und/oder in einer Anode für eine Energiespeichervorrichtung oder für eine Lithium-Ionen-Sekundärbatterie.

13. Anode für eine Lithium-Ionen-Sekundärbatterie, umfassend die poröse nanokristalline Halbleiterschicht nach einem der Ansprüche 8 bis 11.

14. Lithium-Ionen-Sekundärbatterie, umfassend eine Anode nach Anspruch 13.

## Revendications

1. Procédé de production d'une couche semi-conductrice nanocristalline poreuse, comprenant
a) fournir un substrat (10) ayant une surface de substrat (11);
b) appliquer une couche semi-conductrice (12) sur la surface du substrat;
c) appliquer une couche contenant un métal (14) sur la couche semi-conductrice;
d) traiter thermiquement la couche semi-conductrice et la couche contenant du métal à une température (T) et pendant une période de temps (t) telles que la couche semi-conductrice et la couche contenant du métal partiellement interdiffusent et que le semi-conducteur soit au moins partiellement cristallisé; et
e) enlever au moins partiellement le métal.

2. Procédé de la revendication 1,
dans lequel, à l'étape b), une couche semi-conductrice amorphe (12) est formée; et/ou
dans lequel, à l'étape d), la température et la période de temps sont choisies de telle sorte qu'un semi-conducteur cristallisé (18) soit formé sur une couche interdiffusée (20) comprenant un semi-conducteur cristallisé et le métal; et/ou
dans lequel, à l'étape e), le métal est au moins partiellement éliminé par attaque du substrat revêtu traité thermiquement; et/ou
dans lequel, à l'étape e), une couche oxydique (202) du métal est formée sur la couche semi-conductrice nanocristalline poreuse (200); et/ou
dans lequel, après l'étape e) à une étape f), le matériau semi-conducteur supérieur et/ou lâche est éliminé.

3. Procédé selon l'une quelconque des revendications précédentes,
dans lequel le semi-conducteur comprend un ou plusieurs semi-conducteurs du groupe IV A du tableau périodique; et/ou
dans lequel le semi-conducteur comprend Si et/ou Ge; et/ou
dans lequel le métal et le semi-conducteur sont partiellement miscibles ou non miscibles; et/ou
dans lequel le métal comprend au moins un métal soluble dans une solution acide et/ou dans une solution alcaline; et/ou
dans lequel le métal comprend au moins un métal choisi parmi Al, Sn, Zn, Ga, In, Pb et Tl; et/ou
dans lequel la couche contenant un métal comprend au moins un élément choisi parmi Al, Sn, Zn, Ga, In, Pb, Tl et Ge; et/ou
dans lequel la couche oxydique du métal est conductrice d'ions; et/ou
dans lequel la couche oxydique du métal est formée conformément à la couche semi-conductrice nanocristalline poreuse.

4. Procédé selon l'une quelconque des revendications précédentes,
dans lequel le substrat et/ou la surface du substrat est électriquement conducteur; et/ou
dans lequel le substrat et/ou la surface du substrat est choisi parmi Ti, Ni, Cu, Cr, l'acier inoxydable, un polymère électriquement conducteur, une céramique électriquement conductrice ou un mélange de ceux-ci.

5. Procédé selon l'une quelconque des revendications précédentes,
dans lequel au moins l'une des étapes de revêtement b) et c) comprend un dépôt physique en phase vapeur, un dépôt chimique en phase vapeur; et/ou
dans lequel les étapes a) à f) ou au moins les étapes a) à c) sont réalisées par un procès continu transportant le substrat à travers des chambres de traitement subséquentes; et/ou dans lequel, à l'étape b), une couche semi-conductrice ayant une épaisseur supérieure à 300 nm, de préférence de 300 nm à 5 µm est formée.

6. Procédé selon l'une quelconque des revendications précédentes,
dans lequel, après l'étape c) et avant l'étape d), une ou plusieurs bicouches de la couche semi-conductrice et de la couche contenant du métal sont appliquées sur la couche contenant du métal; et/ou
dans lequel, à l'étape d), le traitement thermique est effectué à une température inférieure à la température eutectique de la combinaison de semi-conducteur et de métal ou à une température supérieure à la température eutectique de la combinaison de semi-conducteur et de métal; et/ou
dans lequel la relation entre la température (T) [°C] et la période (t) [min] suit au moins 1 / T étant proportionnelle à log t; et/ou
dans lequel, à l'étape d), le traitement thermique est effectué à une température de 160 à 650°C et/ou pendant une période de temps de 0,15 à 72 h.

7. Procédé selon l'une quelconque des revendications précédentes,
dans lequel, à l'étape d), le traitement thermique est effectué dans une atmosphère de gaz protecteur et/ou sous vide; et/ou
dans lequel, à l'étape e), le substrat revêtu traité thermiquement est attaqué par une solution acide et/ou une solution alcaline.

8. Couche semi-conductrice nanocristalline poreuse pouvant être obtenue ou obtenue par un procédé selon l'une quelconque des revendications précédentes,
dans lequel la couche semi-conductrice (100; 200) est prévue sur un substrat (10) et comprend une surface externe (102) et des macropores (104) s'étendant de la surface externe de la couche semi-conductrice vers le substrat (10), et
dans lequel les macropores ont une profondeur de 600 à 2100 nm.

9. Couche semi-conductrice selon la revendication 8,
dans lequel les macropores ont une taille de pores supérieure à 50 nm; et/ou
dans lequel les macropores ont une largeur de 50 à 1000 nm; et/ou
dans lequel les macropores de la couche semi-conductrice sont formés par des espaces intermédiaires de structures de surface (106); et/ou
dans lequel les structures de surface sont cristallines, de taille nano, en trois dimensions, de forme irrégulière et/ou ont la forme d'une colonne; et/ou
dans lequel les structures de surface ont une largeur de 100 à 1000 nm, une hauteur de 100 à 3000 nm et/ou des espaces intermédiaires de 50 à 2100 nm.

10. Couche semi-conductrice selon la revendication 8 ou 9,
dans lequel l'épaisseur de la couche semi-conductrice est supérieure à 300 nm, de préférence de 300 nm à 5 µm; et/ou
dans lequel les structures de surface semi-conductrices (106) sont revêtues d'une couche oxydique (202) du métal.

11. Couche semi-conductrice selon l'une quelconque des revendications 8 à 10,
dans lequel le semi-conducteur comprend un ou plusieurs semi-conducteurs du groupe IV A du tableau périodique; et/ou
dans lequel le semi-conducteur comprend Si et/ou Ge; et/ou
dans lequel le métal et le semi-conducteur sont partiellement miscibles ou non miscibles; et/ou
dans lequel le métal comprend au moins un métal soluble dans une solution acide et/ou dans une solution alcaline; et/ou
dans lequel le métal comprend au moins un métal choisi parmi Al, Sn, Zn, Ga, In, Pb et Tl; et/ou
dans lequel la couche oxydique comprend au moins un élément choisi parmi Al, Sn, Zn, Ga, In, Pb, Tl et Ge; et/ou
dans lequel le substrat et/ou la surface du substrat est électriquement conducteur; et/ou
dans lequel le substrat et/ou la surface du substrat est choisi parmi Ti, Ni, Cu, Cr, un acier inoxydable, un polymère électriquement conducteur, une céramique électriquement conductrice ou un mélange de ceux-ci; et/ou
dans lequel la couche oxydique du métal est conductrice des ions et/ou conforme à la couche semi-conductrice nanocristalline poreuse.

12. Utilisation d'une couche semi-conductrice nanocristalline poreuse selon l'une des revendications 8 à 11 dans une électrode et/ou dans une anode pour un dispositif de stockage d'énergie ou pour une batterie secondaire lithium-ion.

13. Anode pour une batterie secondaire lithium-ion, comprenant la couche semi-conductrice nanocristalline poreuse selon l'une des revendications 8 à 11.

14. Batterie secondaire lithium-ion comprenant une anode selon la revendication 13.
